# EUROPEAN PATENT APPLICATION

(11) **EP 4 421 855 A2**
(43) Date of publication of application: **28.08.2024**
(21) Application number: 24156576.1
(22) Date of filing: 08.02.2024
(51) Int. Cl.: H01L 21/67, H01L 21/683

(54) **ELECTRONIC COMPONENT TRANSFER SYSTEM AND METHOD**

(30) Priority: 22.02.2023 EP 23158086
(71) Applicant: Nexperia B.V., 6534 AB Nijmegen (NL)
(72) Inventor: Wesselingh, Jasper, Nijmegen (NL)
(74) Representative: Pjanovic, Ilija

(57) **Abstract**

Aspects of the present disclosure relate to an electronic component transfer system. Further aspects of the present disclosure relate to a method for transferring an electronic component. The present disclosure particularly relates to electronic component transfer systems in which an optical light source is used for releasing and transferring electronic components.

According to an aspect of the present disclosure, a drive unit is used for moving the optical light source and/or light beam output by the optical light source to change a position at which it has released a component from the source substrate to a position at which it will release a next component from the source substrate.

## Description

### FIELD

Aspects of the present disclosure relate to an electronic component transfer system. Further aspects of the present disclosure relate to a method for transferring an electronic component. The present disclosure particularly relates to electronic component transfer systems in which an optical light source is used for releasing and transferring electronic components.

### BACKGROUND

In a laser die transfer process, a singulated semiconductor die is transferred from a wafer by ablating the release material by which the semiconductor die is attached to a carrier foil using laser light. The ablation of the release material causes the semiconductor die to be propelled from the carrier foil towards a target substrate. A similar transfer process can also be performed to dispense solder paste, glue or other interconnect materials.

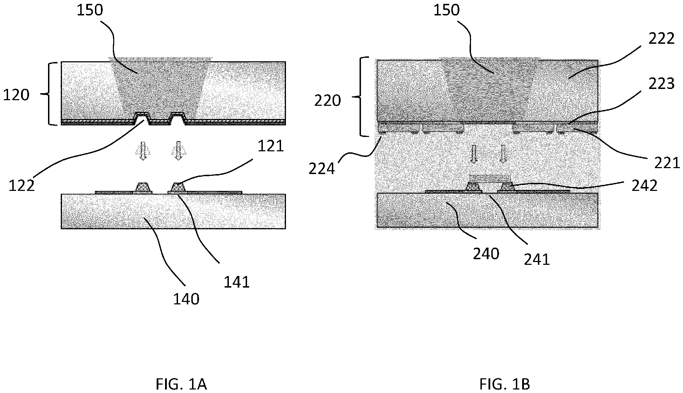

Figures 1A and 1B illustrate a known laser transfer process for the release of discrete solder paste volumes from a structured carrier substrate, and for the release of semiconductor dies from a carrier foil, respectively.

In figure 1A, a source substrate 120 comprises a plurality of cavities 122 in which solder paste is arranged. Source substrate 120 is held on a source carrier (not shown). Using laser light 150, solder paste 121 is released from cavities 122 and is propelled towards a target substrate 140 that is held on a target carrier (not shown). On target substrate 140, a plurality of target positions 141 is defined on which solder paste 121 should be arranged. In figure 1A, a metal pad is arranged at target positions 141.

In figure 1B, source substrate 220 is in the form of a semiconductor wafer that consists of singulated semiconductor dies 221 mounted on a foil 222 using an adhesive 223. Source substrate 220 is held by a source carrier (not shown). On a side facing target substrate 240, semiconductor dies 221 are provided with terminals 224 for enabling an electrical connection to target substrate 240.

Target substrate 240, held by a target carrier (not shown), comprises a plurality of target positions 241 at which semiconductor dies 221 should be arranged. On these positions, one or more metal pads are provided with solder bumps 242 or the like for enabling electrical contact with terminals 224 on semiconductor dies 221 through solder bumps 224.

It is noted that the processes illustrated in figures 1A and 1B can be combined. For example, the process of figure 1A can be performed to arrange solder bumps 242 of figure 1B. After arranging semiconductor dies 221, a reflow process is used during which solder bumps 242 at least partially melt to thereby fixedly and electrically connect terminals 224 to corresponding metal pads on target substrate 240.

In the known processes shown in figures 1A and 1B, source substrate 120, 220 and target substrate 140, 240 are mutually moved for repeatedly bringing an electronic component, i.e. solder paste 121 or semiconductor die 221, in alignment with an empty target position 141, 241. Furthermore, both target position 141, 241 and electronic component 121, 221 should be brought into alignment with laser beam 150. To this end, known laser transfer apparatuses comprise a drive unit for moving the source carrier and target carrier on which source substrate 120, 220 and target substrate 140, 240 are mounted, respectively.

An important performance parameter for transfer apparatuses of the type described above is the number of electronic components that can be arranged per unit time referred to as the throughput. This performance parameter is mostly determined by the speed at which source substrate 120, 220 and target substrate 140, 240 can be accelerated and moved. Unfortunately, the inertial mass associated with the combination of source carrier and source substrate and that of the combination target carrier and target substrate is relatively large. The relatively high inertial mass limits the throughput that can be obtained.

### SUMMARY

According to an aspect of the present disclosure, an electronic component transfer system is provided with improved throughput. According to an aspect of the present disclosure, this object is achieved by an electronic component transfer system that comprises an optical light source, a source carrier for holding a source substrate that comprises a plurality of components, and a target carrier for holding a target substrate that comprises a plurality of target positions at which the components need to be arranged. The system further comprises a first drive unit for moving at least one of the source carrier and target carrier to bring a component from the source substrate into alignment with an empty target position of the target substrate.

The plurality of components can be released using light from the optical light source. For example, the components can be attached to the source substrate or to the source carrier by an adhesive or other attaching agent. The adhesive or attaching action of the adhesive of attaching agent can be terminated using light from the optical light source. For example, the adhesive or attaching agent can be heated by the light such that it loses its adhesive or attachment properties. As an example, the adhesive or attaching agent can at least be partially ablated causing the electronic component to be propelled away from the source substrate. Alternatively, a chemical reaction can be triggered by the light such that the adhesive or attaching agent loses its adhesive or attachment properties.

The source substrate is typically positioned in between the target substrate and the optical light source. This requires at least part of the source substrate to be transparent for the light output by the optical light source in order for the light to reach the adhesive.

According to an aspect of the present disclosure, the system further comprises a second drive unit for moving the optical light source and/or for moving a light beam output by the optical light source. The system additionally comprises a controller configured to control the second drive unit for moving the optical light source and/or light beam output by the optical light source to change a position at which it has released a component from the source substrate to a position at which it will release a next component from the source substrate.

The Applicant has found that the inertial mass associated with accelerating and moving the optical light source or the light beam output by such source is much less than the inertial mass associated with accelerating and moving the source substrate and target substrate. This enables a faster alignment between the light beam from the optical light source, electronic component, and empty target position.

The electronic component transfer is effectuated by using positional information about the positioning of the electronic components on the source substrate and positional information about the target positions on the target substrate to determine the order in which components are picked from the source substrate and the order in which the target positions are filled. This order is determined by minimizing the time required for bringing a component that still needs to be transferred into alignment with an empty target position on the target substrate.

According to an aspect of the present disclosure, the position in space when releasing a component, e.g. relative to a stationary frame, generally changes from component to component. Such change can be realized by physically changing the position of the optical light source. To that end, the second drive unit may comprise an actuator for moving the optical light source. Additionally or alternatively, the second drive unit may comprise a light directing system having movable lenses and/or mirrors for allowing the light beam output by the optical light source to be moved. Such light directing system may for example comprise MEMS driven micro-lenses and/or MEMS driven micro-mirrors.

The controller can be configured to control the first drive unit to mutually move the source carrier and the target carrier to bring the next component in alignment with a target position of the target substrate that is still empty, and to control the optical light source to release the next component.

In general, components that are sequentially arranged on the target substrate are not adjacently arranged on the source substrate. The determination of which component on the source substrate is to be arranged next on the target substrate can be based on the closeness between a component and a suitable empty target position. For example, the controller can be configured to determine, for at least some of the components that have not yet been released, a distance to be covered and/or an amount of time required by the source carrier and/or target carrier for bringing that component into alignment with a nearest available target position on the target substrate that is still empty, and to select a component among the at least some components as the next component based on the determined distance and/or time. For example, the components can be represented by a grid of component positions. Similarly, the empty target positions also form a grid. By mutually moving the source substrate and target substrate, the grids can be mutually shifted. According to an aspect of the present disclosure, a relatively small shift is required to bring a component into alignment with an empty position. Such component is generally not adjacent to the component that was placed last. Accordingly, the light beam output by the optical light source generally has to release a next component at a position different from the position at which the previous component was released. However, as the inertial mass associated with moving the optical light source or the light beam output by the optical light source is relatively small, such movement can be realized within the time required for the component to come into alignment with a suitable empty target position.

In an embodiment, the electronic component transfer system comprises a memory for holding a sequence of first positions the optical light source should be at for releasing the components. Additionally or alternatively, the memory could be configured to hold a sequence of second positions at which the light beam output by the optical light should release the components, a sequence of third positions at which the carrier substrate should be when the components are released, and/or a sequence of fourth positions at which the target substrate should be when the released components are received. The controller can be configured to control the first drive unit based on the sequence of third positions and/or fourth positions, and/or the controller can be configured to control the second drive unit based on the sequence of first positions and/or second positions. Instead of position data, the memory can be configured to hold a sequence of identifications or positions of electronic components on the source substrate and a sequence of identifications or positions of target positions on the target substrate, wherein the controller is configured to control the first drive unit and the second drive unit based on the sequence of identifications or positions of electronic components on the source substrate and the sequence of identifications or positions of target positions on the target substrate.

In both embodiments described above, the controller receives information about which component to place at which target position and information regarding the order in which the components are to be transferred. Such information can be received from an external source. Moreover, such information can be calculated prior to the transfer process. Alternatively, the information is generated within the system itself.

The source substrate may comprise a semiconductor wafer comprising a plurality of singulated semiconductor dies originating from said semiconductor wafer. The plurality of electronic components to be transferred then corresponds to the plurality of singulated semiconductor dies originating from said semiconductor wafer. Alternatively, the source substrate may comprise a structured semiconductor wafer comprising a plurality of singulated semiconductor dies originating from different semiconductor wafers. In this case, the plurality of components corresponds to the plurality of singulated semiconductor dies originating from different semiconductor wafers.

The electronic component transfer system may further comprise a mapping unit for creating a wafer map including position data of the plurality of semiconductor dies. Such wafer map may for example comprise a plurality of coordinates, each coordinate or set of coordinates enabling the controller to pick the component that is associated with that coordinate or set of coordinates.

The electronic component transfer system may further comprise a measuring unit for measuring at least one electrical or optical parameter of the semiconductor dies. The wafer map may in such case comprise an association between the semiconductor dies and/or positions of these semiconductor dies, and the measured at least one electrical or optical parameter for the semiconductor dies.

The abovementioned wafer map, including or excluding measurement data, may be used by the controller for determining which components to pick where from the target substrate. To this end, the controller typically also uses information about the target positions on the target substrate. In further embodiments, the semiconductor dies may be assigned to bins based on the at least one electrical or optical parameter. Such assignment may be performed by the controller or may be performed external of the system. In both cases, the assignment may be included in the wafer map.

The controller can be configured to determine the next semiconductor die to be transferred taking into account the bins of semiconductor dies that have been previously arranged on the target substate in a vicinity of the target position intended for the next semiconductor die. For example, in an embodiment, it may be desired to arrange large numbers of identical semiconductor dies on the target substrate. For example, the target substrate may form a display panel. To obtain a uniform appearance or performance it is preferred to mix the semiconductor dies to such an extent, that semiconductor dies that perform less than average, are arranged close to semiconductor dies that perform more than average.

The present disclosure is not limited to transferring semiconductor dies. For example, aspects of the present disclosure equally relate to transferring solder paste, glue, adhesive, underfill material, or flux.

The source carrier and the target carrier can be configured to be moved relative to each other by the first drive unit along a first direction and along a second direction that is perpendicular to the first direction. The second drive unit can be configured to move the optical light source or the light beam output by the optical light source along at least one of the first direction and second direction.

Typically, the source carrier and target carrier are each arranged to move in a respective plane, which planes are parallel. The optical light source or the light beam output by the optical light source may also be configured to be moved in a plane. This latter plane is preferably parallel to the planes in which the source carrier and target carrier move.

Assuming that the first direction corresponds to an x-direction and the second direction to a y-direction, the following table can be constructed that indicates along which directions the optical light source, OLS, the source carrier, SC, and the target carrier, TC, are able to move.

| OLS | SC | TC |
|---|---|---|
| x | y | x, y |
| x | x, y | y |
| y | x | x, y |
| y | x, y | x |
| x, y | - | x, y |
| x, y | x | y |
| x, y | x, y | - |
| x, y | y | X |

In an embodiment, the first drive unit comprises a primary drive for moving the source carrier along the first direction and/or second direction, and a secondary drive for moving the target carrier along the first direction and/or second direction.

The first drive and the optical light source can be embodied as a galvanometer optical scanner. The first drive, and more in particular the primary and/or secondary drive, may comprise one or more linear motors, spindles or belt drives.

According to a further aspect, the present disclosure relates to a method for transferring an electronic component, comprising using an optical light source for releasing a first electronic component that is arranged on a source substrate held on a source carrier when that electronic component is aligned with an empty target position on a target substrate held on a target carrier. The method further comprises mutually moving the source carrier and the target carrier to bring a second electronic component arranged on the source substrate that is to be transferred next in alignment with a further empty target position on the target substrate and moving the optical light source and/or light beam output by the optical light source to change from a position at which it has released the first electronic component from the source substrate to a position at which it will release the second electronic component. Next, the optical light source is used for releasing the second electronic component.

The method may comprise determining, for at least some of the electronic components arranged on the source substrate that have not yet been released, a distance to be covered and/or an amount of time required by the source carrier and/or target carrier for bringing that electronic component into alignment with a nearest available target position on the target substrate that is still empty, and selecting an electronic component among the at least some electronic components as the second electronic component based on the determined distance and/or time. Such determination can also be performed prior to the transfer process. For example, a wafer map as described above can be used to determine which electronic component is to be arranged at which target position and in which sequence. In an additional or alternative embodiment, a wafer map comprising position information of still available dies and a substrate map comprising position information of still available target positions is continuously updated during the transfer process. For example, when a semiconductor die at a given source position on the wafer map is transferred to a given target position on the substrate map, the wafer map is updated to reflect that said source position is now empty and the substrate map is updated to reflect that said target position is no longer empty. The initial substrate and wafer maps are typically provided to the transfer system prior to the transfer process.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates two examples of a known laser transfer process;
Figure 2 illustrates an embodiment of a transfer system according to an aspect of the present disclosure;
Figure 3 illustrates a general concept according to an aspect of the present disclosure;
Figure 4 illustrates the assignment of semiconductor dies to bins;
Figure 5 illustrates a top view of an embodiment of a transfer system according to an aspect of the present disclosure; and
Figure 6 illustrates an example of a method for transferring an electronic component in accordance with an aspect of the present disclosure.

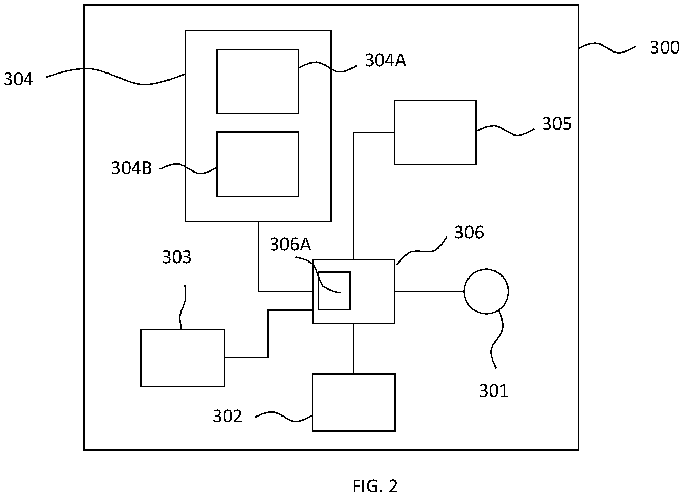

Figure 2 illustrates an embodiment of the transfer system 300 in accordance with an aspect of the present disclosure. System 300 comprises an optical light source 301, such as a laser. System 300 further comprises a source carrier 302 for holding a source substrate and a target carrier 303 for holding a target substrate. Source carrier 302 refers to a structure that can hold the source substrate and by which the source substrate can be moved. Similarly, target carrier 303 refers to a structure that can hold the target substrate and by which the target substrate can be moved.

System 300 comprises a first drive unit 304 for moving at least one of source carrier 302 and target carrier 303, and a second drive unit 305 for moving optical light source 301 and/or for moving a light beam output by optical light source 301. First drive unit 304 comprises a primary drive 304A for moving source carrier 302 and/or a secondary drive 304B for moving target carrier 303.

System 300 also comprises a controller 306 configured to control first drive unit 304, second drive unit 305, and optical light source 301. Controller 306 may comprise a memory 306A. Memory 306A may be used to store information regarding which component to arrange at which target position and in which order as will be discussed later.

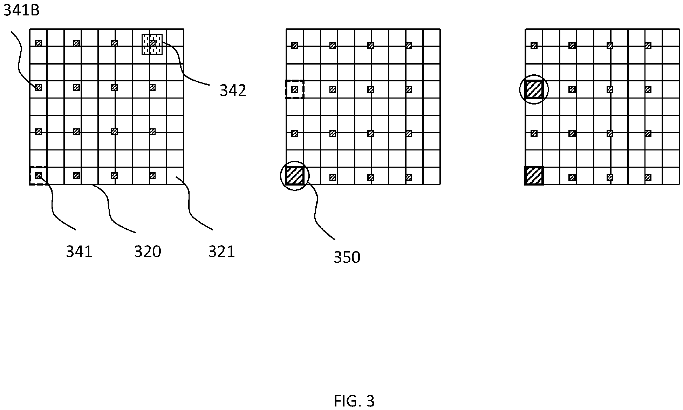

Figure 3 illustrates a general concept of an electronic component transfer system. Figure 3 shows part of the source substrate in the form of a wafer 320 that comprises a plurality of singulated semiconductor dies 321. In the same figure, a grid is shown of target positions 341 on the target substrate. At each target position 341, a die pad 342 is provided on the target substrate. It is noted that in figure 3 (left), only one die pad 342 is shown for illustrative purposes. Die pads 342 are larger than semiconductor dies 321 and are arranged in a matrix in which distances between neighboring die pads 342 is larger than the distances between neighboring semiconductor dies 321 on wafer 320.

As shown in the figure on the left, and as indicated by the hashed rectangle, the semiconductor die 321 in the lower left corner is aligned with a target position 341. At this position, semiconductor die 321 will be released using light 350 from an optical light source and the corresponding target position 341 will be filled. In the center figure this is indicated by the patterned rectangle.

As a next step, source substrate 320 and the target substrate are mutually moved to bring a next semiconductor die 321 into alignment with an empty target position 341. In prior art systems, the component to be transferred next is generally the component that is arranged next to the component that was transferred last. In addition, the target position that is to receive the next component is arranged adjacent to the target position that received the latest component. This arrangement for the components and target positions in prior art systems is required for keeping the time between adjacent component transfers as low as possible.

According to an aspect of the present disclosure the optical light source is moved. This allows alignment to be obtained between a semiconductor die 321 still arranged on source substrate 320 and an empty target position 341 on the target substrate with a relatively small mutual displacement between the source carrier holding source substrate 320 and the target carrier holding the target substrate. Such alignment is shown using the hashed rectangle in the center figure. It can be verified that the mutual displacement between source carrier and target carrier for bringing semiconductor die 341B into alignment is much smaller than the mutual displacement required in prior art systems. In these latter systems, because the optical light source is stationary, the source substrate has to be moved by a distance corresponding to the width or length of the semiconductor die and the target substrate has to be moved by a distance corresponding to the pitch between adjacent target positions. Both these distances are generally much larger than the distance required for moving from the situation shown in figure 3, left, to the situation shown in figure 3, center.

After releasing semiconductor die 341B using light 350, the situation as shown in figure 3, right, is obtained.

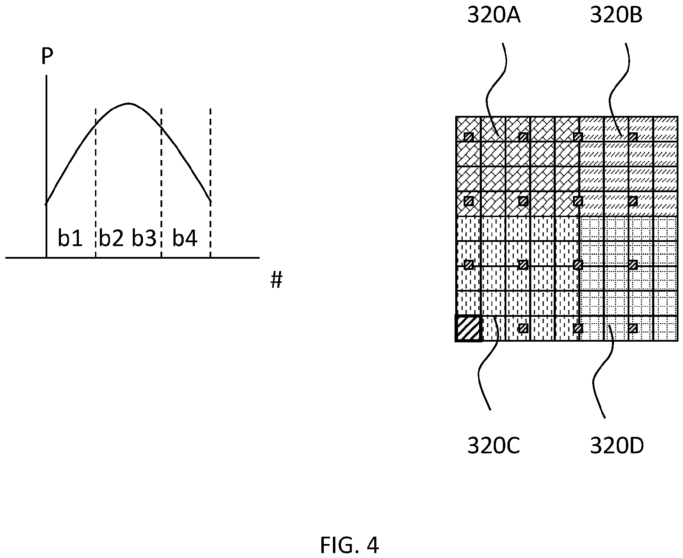

Figure 4, left, illustrates a distribution of a value for an electrical or optical parameter P, such as resistance, colour temperature or the like, as a function of the number # of components having that Value. The semiconductor dies can be assigned to bins b1-b4, each bin indicating semiconductor dies having a particular range for parameter P.

Figure 4, right, illustrates a schematic representation of how the performance of semiconductor dies 321 is distributed over source substrate 320. In this figure, 4 regions 320A-320D can be identified in which regions the semiconductor dies belong to bins b1-b4, respectively. The last semiconductor die placed on target substrate corresponds to the patterned rectangle. This semiconductor die corresponds to bin b1. When arranging further semiconductor dies next to that semiconductor die it should be ensured that semiconductor dies of bin b4 are placed in its vicinity so that the off-average performance of semiconductor dies belonging to bin b1 can be compensated by the off-average performance of semiconductor dies belonging to bin b4. By taking into account the bins of semiconductor dies that are already arranged on the target substrate, it may well be that the component to be transferred next is not the component for which alignment with an empty target position can be reached in the shortest amount of time.

Determining which component to arrange on which target position can be performed prior to the transfer process. For example, information regarding the target positions on the target substrate, and information regarding the positions of the semiconductor dies can be fed to controller 306 that calculates a sequence of positions. For example, controller 306 may calculate a sequence of positions of semiconductor dies on the source substrate, wherein the sequence represents the order in which the semiconductor dies should be transferred. Controller 306 may also calculate a corresponding sequence of target positions on which the semiconductor dies need to be arranged. Based on these positions, controller 306 can determine how to control the movement of the source carrier, target carrier, and optical light source. Alternatively, controller 306 may calculate the displacements required for the source substrate, target substrate, and optical light source.

The abovementioned positional data may be loaded into memory 306A of the transfer system. Alternatively, the information can be calculated during the transfer process and/or within the transfer system.

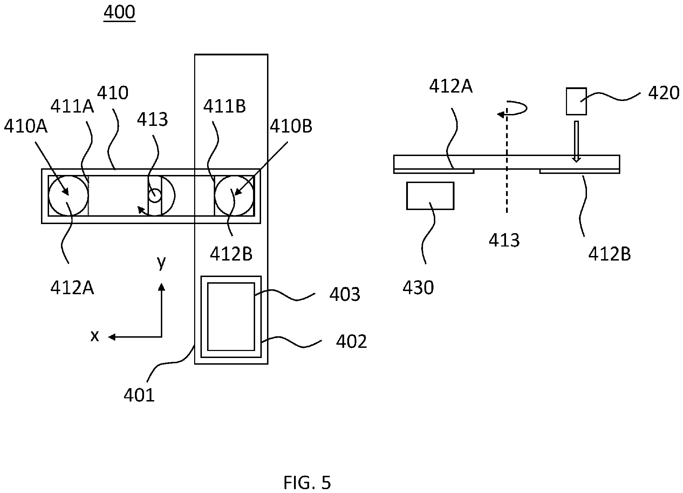

Figure 5 illustrates a top view of a transfer system 400 in accordance with the present disclosure. As shown, system 400 comprises a guiding unit 401 with a target carrier 402 on which a target substrate 403 can be arranged. Guiding unit 401 enables target carrier 402 to be moved in the y-direction. System 400 further comprises a secondary drive for moving target carrier in the x-direction and y-direction.

System 400 further comprises a source unit comprising a rotatable frame 410 having two positions 410A, 410B. At these two positions, a source carrier 411A, 411B is provided on which a source substrate 412A, 412B can be arranged. Separate primary drives are provided for moving the source carriers 411A, 411B in an x-direction and y-direction.

Frame 410 can rotate around axis 413 for switching the positions of source substrates 412A, 412B.

System 400 comprises an optical light source in the form of a laser 420 that is arranged above source substrate 412B. A second drive is used for moving laser 420 or the light beam output by laser 420 in a x-direction and y-direction. The second drive and laser 420 are embodied as a galvanometer optical scanner.

When a source substrate is arranged at position 410A, it can be measured by a measuring unit 430 that can be used for measuring an electrical or optical parameter and/or for mapping source substrate 412A, which can be in the form of a semiconductor wafer.

The measurement information can be fed to memory 306A, which information can be used by controller 306 for controlling the galvanometer optical scanner, the primary drive, and the secondary drive.

When a source substrate 412B is arranged at position 410B, it can be moved in the x-direction and y-direction during the transfer process. With rotatable frame 410, it is possible to perform the measurements using measurement unit 430 on one source substrate 412A arranged at position 410A, while at the same time performing a transfer process on a second substrate 412B arranged at position 410B.

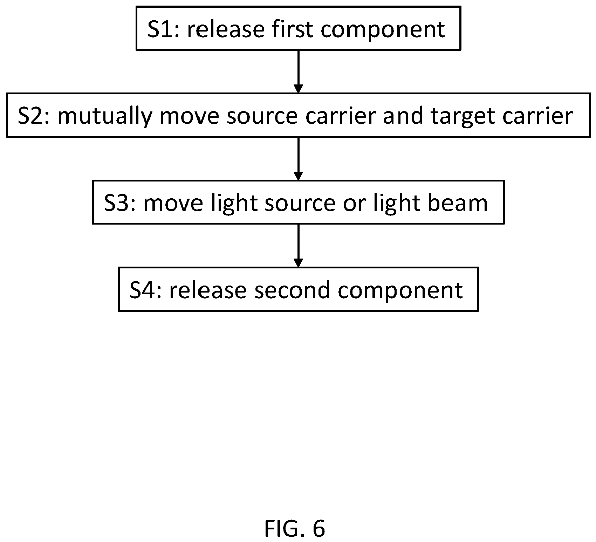

Figure 6 illustrates a method in accordance with an aspect of the present disclosure. This method comprises a step S1 of using an optical light source for releasing a first component that is arranged on a source substrate held on a source carrier when that component is aligned with an empty target position on a target substrate held on a target carrier. The method further comprises a step S2 of mutually moving the source carrier and the target carrier to bring a second component arranged on the source substrate that is to be transferred next in alignment with a further empty target position on the target substrate. As a next, previous or concurrent step S3, the optical light source and/or light beam output by the optical light source is moved to change a position at which it has released the first component from the source substrate to a position at which it will release the second component. Finally, during step S4, the optical light source is used for releasing the second component.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. An electronic component transfer system (300, 400), comprising:
an optical light source (301; 420);
a source carrier (302; 411A, 411B) for holding a source substrate (320; 412A, 412B) that comprises a plurality of components (321);
a target carrier (303, 402) for holding a target substrate (340, 403) that comprises a plurality of target positions (341) at which the components need to be arranged;
a first drive unit (304) for moving at least one of the source carrier and target carrier to bring a component from the source substrate into alignment with an empty target position of the target substrate;
a second drive unit (305) for moving the optical light source and/or for moving a light beam output by the optical light source;
a controller (306) configured to control the second drive unit for moving the optical light source and/or light beam output by the optical light source to change a position at which it has released a component from the source substrate to a position at which it will release a next component from the source substrate,
wherein the controller is configured to:
determine, for at least some of the components that have not yet been released, a distance to be covered and/or an amount of time required by the source carrier and/or target carrier for bringing that component into alignment with a nearest available target position of the target substrate that is still empty; and
select a component among the at least some components as the next component based on the determined distance and/or time.

2. The electronic component transfer system according to claim 1, wherein the second drive unit comprises an actuator for moving the optical light source.

3. The electronic component transfer system according to claim 1 or 2, wherein the second drive unit comprises a light directing system having movable lenses and/or mirrors for allowing the light beam output by the optical light source to be moved.

4. The electronic component transfer system according to any of the previous claims, wherein the controller is configured to:
control the first drive unit to mutually move the source carrier and the target carrier to bring said next component in alignment with a target position of the target substrate that is still empty; and
control the optical light source to release said next component.

5. The electronic component transfer system according to any of the claims, further comprising a memory for holding:
a sequence of first positions the optical light source should be at for releasing the components, a sequence of second positions at which the light beam output by the optical light should release the components, a sequence of third positions at which the carrier substrate should be when the components are released, and/or a sequence of fourth positions at which the target substrate should be when the released components are received, wherein the controller is configured to control the first drive unit based on the sequence of third positions and/or fourth positions, wherein the controller is configured to control the second drive unit based on the sequence of first positions and/or second positions; or
a sequence of identifications or positions of electronic components on the source substrate and a sequence of identifications or positions of target positions on the target substrate, wherein the controller is configured to control the first drive unit and the second drive unit based on the sequence of identifications or positions of electronic components on the source substrate and the sequence of identifications or positions of target positions on the target substrate.

6. The electronic component transfer system according to any of the previous claims,
wherein the source substrate comprises a semiconductor wafer comprising a plurality of singulated semiconductor dies originating from said semiconductor wafer, and wherein the plurality of components corresponds to the plurality of singulated semiconductor dies originating from said semiconductor wafer; or
wherein the source substrate comprises a structured semiconductor wafer comprising a plurality of singulated semiconductor dies originating from different semiconductor wafers, and wherein the plurality of components corresponds to the plurality of singulated semiconductor dies originating from different semiconductor wafers.

7. The electronic component transfer system according to claim 6, further comprising a mapping unit (430) for creating a wafer map including position data of the plurality of semiconductor dies.

8. The electronic component transfer system according to claim 7, further comprising a measuring unit (430) for measuring at least one electrical or optical parameter of the semiconductor dies, wherein the wafer map comprises an association between the semiconductor dies and/or the positions of these semiconductor dies, and the measured at least one electrical or optical parameter for the semiconductor dies.

9. The electronic component transfer system according to claim 8, wherein the semiconductor dies are assigned to bins (b1-b4) based on the at least one electrical or optical parameter, wherein the controller is configured to determine the next semiconductor die taking into account the bins of semiconductor dies that have been previously arranged on the target substate in a vicinity of the target position intended for the next semiconductor die.

10. The electronic component transfer system according to any of the claims 1-6,
wherein the electronic component is a solder paste, glue, adhesive, underfill material, or flux.

11. The electronic component transfer system according to any of the previous claims, wherein the source carrier and the target carrier are configured to be moved relative to each other by the first drive unit along a first direction and along a second direction that is perpendicular to the first direction;
wherein the second drive unit is configured to move the optical light source or the light beam output by the optical light source along at least one of the first direction and second direction.

12. The electronic component transfer system according to claim 11, wherein the first drive unit comprises a primary drive (304A) for moving the source carrier along the first direction and/or second direction, and a secondary drive (304B) for moving the target carrier along the first direction and/or second direction;
wherein the first drive and the optical light source are preferably embodied as a galvanometer optical scanner; and
wherein the first drive preferably comprises one or more linear motors, spindles, or belt drives.

13. A method for transferring an electronic component, comprising:
using (S1) an optical light source for releasing a first electronic component that is arranged on a source substrate held on a source carrier when that electronic component is aligned with an empty target position on a target substrate held on a target carrier;
mutually moving (S2) the source carrier and the target carrier to bring a second electronic component arranged on the source substrate that is to be transferred next in alignment with a further empty target position on the target substrate;
moving (S3) the optical light source and/or light beam output by the optical light source to change from a position at which it has released the first component from the source substrate to a position at which it will release the second component; and
using (S4) the optical light source for releasing the second electronic component,
wherein the method further comprising.
for at least some electronic components arranged on the source substrate that have not yet been released, determining a distance to be covered and/or an amount of time required by the source carrier and/or target carrier for bringing that electronic component into alignment with a nearest available target position on the target substrate that is still empty; and
selecting an electronic component among the at least some electronic components as the second component based on the determined distance and/or time.
